# EUROPÄISCHE PATENTSCHRIFT

(11) **EP 2 009 979 B1**
(45) Veröffentlichungstag und Bekanntmachung des Hinweises auf die Patenterteilung: **28.11.2012**
(21) Anmeldenummer: 08104289.7
(22) Anmeldetag: 06.06.2008
(51) Int. Cl.: H05K 13/04, H05K 13/08

(54) **Vorrichtung und Verfahren zum Bestücken von Substraten mit Bauelementen**
Device and method for populating substrates with components
Dispositif et procédé d'implantation de substrats à l'aide de composants

(30) Priorität: 26.06.2007 DE 102007029373
(43) Veröffentlichungstag der Anmeldung: 31.12.2008
(73) Patentinhaber: ASM Assembly Systems GmbH & Co. KG, 81379 München (DE)
(72) Erfinder: Brandis, Tilo, 81479, München (DE); Liegel, Werner, 82538, Geretsried (DE); Müller, Werner, 83607, Holzkirchen (DE); Negele, Robert, 85598, Baldham (DE)
(74) Vertreter: Dilg, Haeusler, Schindelmann Patentanwaltsgesellschaft mbH

(56) Entgegenhaltungen:
- WO-A1-2004/043126
- DE-A1- 10 026 188
- DE-A1- 19 835 876
- US-A- 5 084 959
- US-A- 5 694 219
- US-A1- 2005 108 873

## Beschreibung

Die Erfindung bezieht sich auf Vorrichtung zum Bestücken von Substraten mit Bauelementen mit einem X-Y-Positioniersystem, welches mindestens einen Träger aufweist und mit mindestens einer Bauelementehalteeinrichtung, die beweglich am Träger angeordnet ist. Darüber hinaus bezieht sich die Erfindung auf ein Verfahren zum Bestücken von Substraten mit Bauelementen, bei dem mittels einer an einem Träger eines X-Y-Positioniersystems angeordneten Bauelementehalteeinrichtung Bauelemente aus Zuführeinheiten entnommen und auf einem Substrat abgesetzt werden.

Bei der automatischen Bestückung von Substraten wie im DE-A1-9 835 876 mit Bauelementen werden mit Hilfe einer Bauelementehalteeinrichtung, beispielsweise eines Bestückkopfes, der mindestens einen Greifer oder eine Saugpipette oder auch eine Mehrzahl an Greifern bzw. Saugpipetten aufweisen kann, Bauelemente aus Zuführeinheiten entnommen und mit Hilfe eines X-Y-Positioniersystems, an welchem die Bauelementehalteeinrichtung angeordnet ist, in Richtung eines Substrats bewegt und dort an einer vorgegebenen Position auf das Substrat aufgesetzt. In der Regel werden die Substrate mit Hilfe von Transportvorrichtungen in einer Transportrichtung durch eine Bestücklinie bewegt und dabei mit verschiedenen Bauelementen bestückt. In einer Bestücklinie können mehrere Bestückautomaten als Vorrichtungen zum Bestücken angeordnet sein. Zu Beginn einer solchen Bestücklinie wird in der Regel ein Drucker zum Bedrucken der Substrate aufgebaut und am Ende einer Bestücklinie ist ein Reflow-Ofen vorgesehen, der dafür sorgt, dass die Bauelemente auf den Substraten durch Schmelzen von Lötzinn verbunden werden.

Zur Inspektion der bestückten Substrate bzw. zur Inspektion der Qualität des Druckvorgangs werden heutzutage separate Automaten verwendet, die eine so genannte Automated-Optical-Inspection (AOI)-Funktion aufweisen. Diese Automaten befinden sich beispielsweise in der Bestücklinie im Anschluss an einen Bestückautomaten, bzw. im Anschluss an den Drucker. Speziell bei kleinen Bestückinhalten, die im Anschluss an einen Bestückvorgang einer AOI-Inspektion unterworfen werden, ist dies für die Anwender allerdings mit einem hohen Kostenaufwand und großem Platzbedarf in der Fertigung verbunden. Die Inspektion dient dabei beispielsweise der Kontrolle darüber, ob die vorgesehenen Bauelemente vollständig auf dem bestückten Substrat vorhanden sind.

Es ist daher die Aufgabe der Erfindung, eine Vorrichtung und ein Verfahren zum Bestücken von Substraten mit Bauelementen anzugeben, mit deren Hilfe eine optische Inspektion mit geringerem Kostenaufwand und kleinerer Stellfläche ermöglicht wird.

Die Aufgabe wird erfindungsgemäß gelöst durch eine Vorrichtung und ein Verfahren der eingangs genannten Art mit den kennzeichnenden Merkmalen der Patentansprüche 1 und 9.

Die erfindungsgemäße Vorrichtung, beispielsweise ein Bestückautomat, weist dabei mindestens eine Bauelementhalteeinrichtung auf, welche an einem Träger eines X-Y-Positioniersystems beweglich angeordnet ist. Weiterhin die Vorrichtung ein optisches Inspektionssystem zur Inspektion des Substrats auf, welches mindestens eine Kamera beinhaltet, die beweglich an dem Träger des X-Y-Positioniersystems angeordnet ist, wobei die Bauelementhalteeinrichtung und die Kamera an verschiedenen Längsseitenflächen, insbesondere an einender gegenüberliegenden Seitenflächen, des länglichen Trägers angeordnet sind. Damit wird die AOI-Funktionalität zusammen mit einer Bauelementehalteeinrichtung in einem Bestückautomaten integriert. Somit ist es nicht mehr erforderlich für die AOI-Funktionalität einen eigenen Automaten und den damit verbundenen Platzbedarf und die höheren Kosten vorzusehen. Weiterhin kann der Träger, der für die Bauelementehalteeinrichtung bereits im Bestückautomaten vorgesehen ist, zusätzlich benutzt werden, um daran die Kamera zu befestigen. Eine eigene Positioniereinrichtung ist nicht erforderlich.

Als optisches Inspektionssystem sind dabei beispielsweise Vorrichtungen denkbar, die eine Flächenkamera zu Aufnahme eines zweidimensionalen Oberflächenbereichs der Substrate beinhalten oder auch Zeilenkameras, die durch eine Bewegung parallel zum Substrat und senkrecht zur Anordnung der Zeile einen Oberflächenbereich aufnehmen. Auch Laserquellen und Kameras zur Auswertung von reflektierten Laserstrahlen für Lasertriangulationsverfahren können als optisches Inspektionssystem eingesetzt werden.

In einer vorteilhaften Ausgestaltung sind die Kamera und die Bauelementehalteeinrichtung an einem gemeinsamen x-Schlitten gemeinsam beweglich am Träger angeordnet. Dadurch ist nur ein x-Schlitten für die Bewegung der Kamera des optischen Inspektionssystems und die Bauelementehalteeinrichtung erforderlich.

In einem weiteren Ausführungsbeispiel ist vorgesehen, dass die Kamera und die Bauelementehalteeinrichtung jeweils an einem separaten Schlitten am Träger angeordnet sind, womit die Kamera und die Bauelementehalteeinrichtung unabhängig voneinander am Träger bewegt werden können. Dadurch lassen sich die Bestückung eines Substrats mit Bauelementen und die optische Inspektion eines bestückten Substrats parallelisieren, so dass beispielsweise die Bauelementehalteeinrichtung ein Substrat bestückt, während die Kamera gleichzeitig ein weiteres bereits bestücktes Substrat optisch inspiziert.

Darüber hinaus ist es möglich, dass die Bauelementehalteeinrichtung in einem Teilbereich des Substrats bestückt, während die Kamera in einem anderen Teilbereich des Substrats bereits bestückte Bauelemente inspiziert. Außerdem ist es möglich, dass die Kamera vor dem eigentlichen Bestückprozess die Qualität des Druckvorgangs anhand der bedruckten Leiterbahnen in einem ersten Teilbereich des Substrats überprüft, während die Bauelementehalteeinrichtung gleichzeitig in einem bereits überprüften Teilbereich des Substrats Bauelemente setzt.

In vorteilhafter Weise ist vorgesehen, dass eine standardisierte elektrische Schnittstelle für Bauelementehalteeinrichtungen bzw. für die Kamera am jeweiligen Träger vorgesehen ist. Damit lässt sich die Vorrichtung zum Bestücken von Substraten mit Bauelementen je nach Bedarf mit Bauelementehalteeinrichtungen (beispielsweise auch unterschiedlichen Bestückköpfen für die Bestückung von unterschiedlichen Bauelementen) bzw. für unterschiedliche Kameras auslegen.

Bei unkritischen Bestückvorgängen lässt sich beispielsweise die Vorrichtung mit zwei Bauelementehalteeinrichtungen versehen, während bei kritischen Bestückvorgängen statt der einen Bauelementehalteeinrichtung in einfacher Weise die Kamera eines optischen Inspektionssystems am Träger befestigt werden kann.

Gemäß einer vorteilhaften Ausgestaltung der Vorrichtung ist eine Steuereinrichtung vorgesehen zum Auswerten von Inspektionsergebnissen des optischen Inspektionssystems und zum Berücksichtigen der Inspektionsergebnisse bei nachfolgenden Bestückvorgängen mit der Bauelementehalteeinrichtung.

Falls die Kamera als zeilenförmig ausgebildete Kamera ausgebildet ist, lässt sich über die Bewegung der Kamera am Träger durch den Schlitten ein Oberflächenscan des Substrats in einfacher Weise realisieren.

Die optische Inspektion kann dabei in vorteilhafter Weise vor, während bzw. nach dem Bestücken des Substrats erfolgen. Falls die optische Inspektion noch während der Bestückung des Substrats erfolgt, kann auch sofort noch eine Lagekorrektur eines ungenau bestückten Bauelementes durch Wiederaufnehmen durch die Bauelementehalteeinrichtung und Neuabsetzen des betreffenden Bauelementes erfolgen.

Die optische Inspektion kann dabei auf der gesamten Oberfläche des Substrats bzw. nur in ausgewählten Bereichen erfolgen. Außerdem ist es möglich, dass nur bei vorher ausgewählten Bauelementen nach der Bestückung dieser ausgewählten Bauelemente eine optische Inspektion erfolgt. Dadurch werden nur kritische Bauelemente inspiziert, was eine Zeitreduktion gegenüber einer vollständigen Inspektion der gesamten Oberfläche des Substrats bewirkt.

In vorteilhafter Weise lassen sich unterschiedliche Kameras, beispielsweise Kameras für Lasertriangulationsverfahren bzw. Kameras mit unterschiedlichem Auflösungsvermögen für unterschiedliche Inspektionsaufgaben vorsehen und jeweils die geeignete Kamera für die jeweilige Inspektionsaufgabe auswählen und beweglich am X-Y-Positioniersystem anzuordnen.

In vorteilhafter Weise werden die Ergebnisse des optischen Inspektionssystems ausgewertet und für nachfolgende Bestückprozesse benutzt, dadurch lassen sich für nachfolgende Bestückprozesse eventuelle Ungenauigkeiten am X-Y-Positioniersystem ausgleichen und bessere Bestückergebnisse erzielen.

Die Erfindung wird in Ausführungsbeispielen anhand der Figuren der Zeichnung näher erläutert.

Dabei zeigen
- Fig. 1: ein erstes Ausführungsbeispiel einer Vorrichtung zum Bestücken von Substraten mit Bauelementen in einer schematischen Draufsicht mit gemeinsam bewegbaren Kamera- und Bauelementehalteeinrichtungen,
- Fig. 2: ein zweites Ausführungsbeispiel mit einer Kamera und einer Bauelementehalteeinrichtung an verschiedenen Portalen eines X-Y-Positioniersystems,
- Fig. 3: ein drittes Ausführungsbeispiel in einer schematischen Draufsicht mit an einem Träger aber unterschiedlichen Schlitten befestigten Kameras bzw. Bauelementehalteeinrichtungen,
- Fig. 4: ein viertes Ausführungsbeispiel einer Vorrichtung zum Bestücken von Substraten mit Bauelementen in schematischer Draufsicht und
- Fig. 5: ein fünftes Ausführungsbeispiel einer Vorrichtung zum Bestücken von Substraten mit Bauelementen in schematischer Draufsicht.

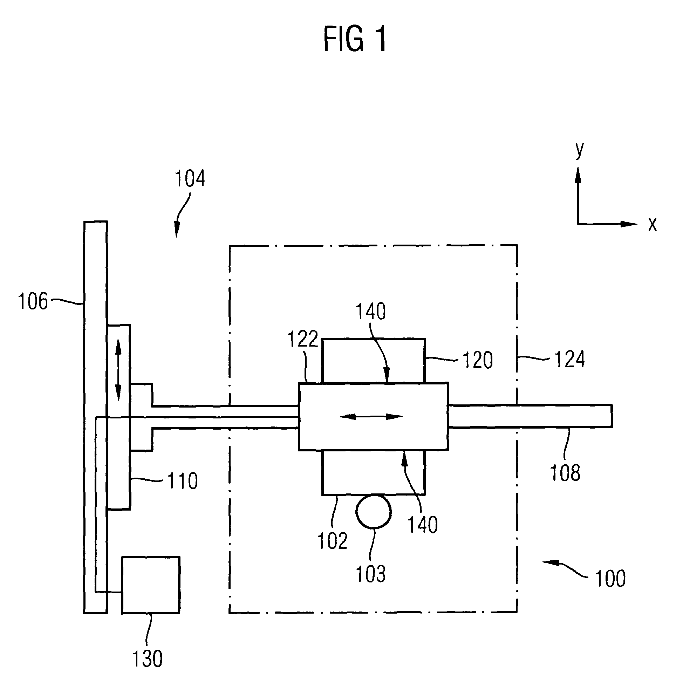

In Fig. 1 ist in schematischer Draufsicht ein Bestückautomat 100 als Vorrichtung zum Bestücken von Substraten mit Bauelementen dargestellt, der mit Hilfe einer Bauelementehalteeinrichtung 102 (schematisch ist eine Saugpipette 103 dargestellt) Bauelemente (nicht dargestellt) aus Zufuhreinheiten (nicht dargestellt) entnimmt und mittels eines X-Y-Positioniersystems 104 über einem Substrat 124 positioniert. Das x-y-Positioniersystem umfasst dabei einen sich in Y-Richtung erstreckenden y-Träger 106 und einen sich dazu im wesentlichen senkrecht in x-Richtung erstreckenden x-Träger 108, wobei der sich in x-Richtung erstreckende x-Träger 108 über einen y-Schlitten 110 am y-Träger 106 beweglich angeordnet ist.

Die Bauelementehalteeinrichtung 102 ist zusammen mit einer Kamera 120 eines optischen Inspektionssystems gemäß an einem x-Schlitten 122 am x-Träger 108 beweglich angeordnet und somit gemeinsam mit der Kamera 120 in X-Richtung entlang des x-Trägers 108 beweglich. Die Verbindung der Kamera 120 bzw. der Bauelementehalteeinrichtung 102 am x-Schlitten kann dabei beispielsweise durch eine standardisierte elektrische und/oder mechanische Schnittstelle 140 realisiert sein, was einen einfachen Wechsel unterschiedlicher Konfigurationen ermöglicht.

Durch die Bewegung des y-Schlittens 110 am y-Träger 106 und des x-Schlittens 122 am x-Träger 108 lassen sich beliebige Positionen oberhalb des schematisch angedeuteten Substrats 124 erreichen, um dort die aufgenommenen Bauelemente abzusetzen.

Der x-Schlitten 122 und der y-Schlitten 110 sind dabei beispielsweise über Riemenantriebe oder über Linearmotoren angetrieben.

Der Bestückautomat 100 weist darüber hinaus eine Steuereinrichtung 130 auf, die mit dem optischen Inspektionssystem 120 sowie dem y-Schlitten 110 und dem x-Schlitten 122 verbunden ist und den y-Schlitten 110 und den zweiten Schlitten 122 so ansteuert, dass Ergebnisse des optischen Inspektionssystems 120 für die Bestückung nachfolgender Bauelemente auf nachfolgende Substrate berücksichtigt werden kann. Dadurch kann im Laufe eines Bestückprozesses auf unterschiedlichen Substraten eine Erhöhung der Setzgenauigkeit durch die Bauelementehalteeinrichtung 102 erzielt werden.

Das optische Inspektionssystem umfasst dabei zum einen die Kamera 120 als auch zumindest Teile der Steuereinrichtung 130, die für die Auswertung zuständig sind.

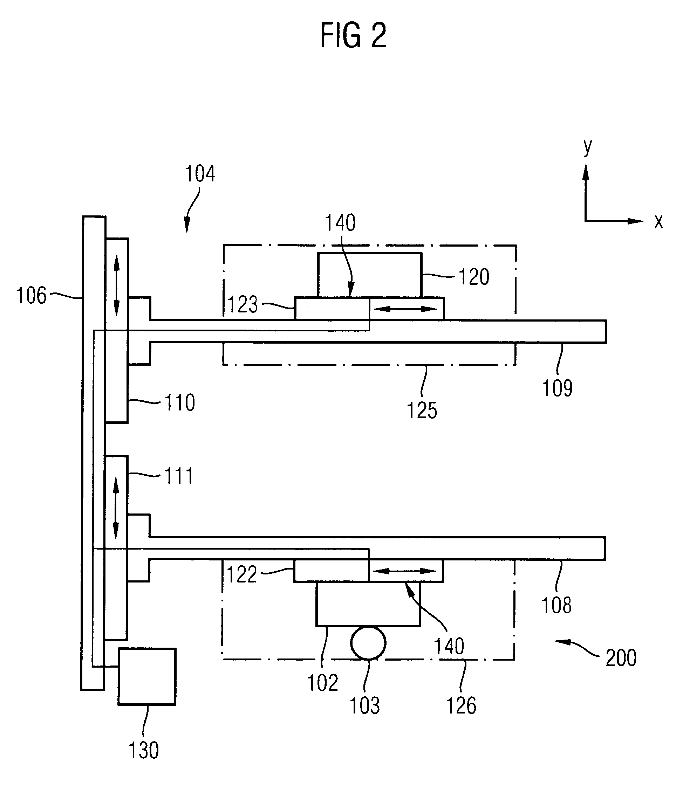

Im in Fig. 2 dargestellten zweiten Ausführungsbeispiel eines Bestückautomaten 200 als Vorrichtung zum Bestücken von Substraten mit Bauelementen sind am y-Träger 106 zwei y-Schlitten 110, 111 angeordnet, an denen jeweils ein x-Träger 108, 109 beweglich in Y-Richtung entlang des y-Trägers 106 angeordnet sind. Die y-Schlitten 110, 111 sind dabei unabhängig voneinander beweglich, allerdings ist bei der Bewegung darauf zu achten, dass es zu keinen Kollisionen kommt.

Dabei ist die Bauelementehalteeinrichtung 102 an einem ersten x-Schlitten 122 am x-Träger 108 in X-Richtung beweglich angeordnet und die Kamera 120 des optischen Inspektionssystems an einem weiteren x-Schlitten 123 am weiteren x-Träger 109 in X-Richtung beweglich angeordnet. Durch die getrennte Anordnung der Kamera 120 und der Bauelementehalteeinrichtung 102 lassen sich der Bestückvorgang und die optische Inspektion unabhängig voneinander durchführen. So kann beispielsweise die Kamera 120 beispielsweise noch unbearbeitete Substrate (hier exemplarisch ein unbearbeitetes Substrat 125) auf Genauigkeit der gedruckten Leiterbahnen überprüfen, während die Bauelementehalteeinrichtung 102 auf bereits überprüfte Substrate (hier exemplarisch ein bedrucktes Substrat 126) Bauelemente aufsetzt. Darüber hinaus ist es denkbar, dass die Kamera 120 bereits von der Bauelementehalteeinrichtung 102 bestückte Substrate überprüft.

Dabei kann die standardisierte Schnittstelle 140 von der Bauelementehalteeinrichtung bzw. der Kamera zum jeweiligen Schlitten 122, 123 bzw. zum jeweiligen Träger 108, 109 vorgesehen sein, um verschiedene Konfigurationen zu ermöglichen und einfach zwischen verschiedenen Konfigurationen zu wechseln.

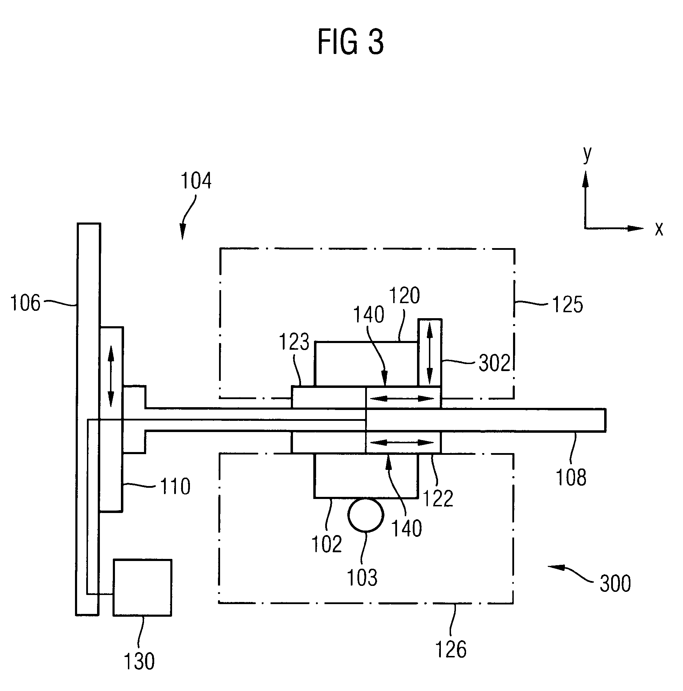

Im dritten Ausführungsbeispiel in Fig. 3 ist für den Bestückautomaten 300 als Vorrichtung zum Bestücken von Substraten mit Bauelementen am y-Träger 106 über den y-Schlitten 110 der x-Träger 108 in Y-Richtung beweglich angeordnet, wobei die Bauelementehalteeinrichtung 102 am ersten x-Schlitten 122 und die Kamera 120 am weiteren x-Schlitten 123 in Y-Richtung auf gegenüberliegenden Seiten des x-Trägers 108 angeordnet sind. Auch mit diesem Ausführungsbeispiel lassen sich die Kamera 120 und die Bauelementehalteeinrichtung 102 in X-Richtung unabhängig voneinander bewegen.

Darüber hinaus kann vorgesehen werden, dass über eine weitere Bewegungsvorrichtung 302 die Kamera 120 in geringem Maße, beispielsweise im Bereich von 5 bis 10 mm in Y-Richtung eine vom y-Schlitten 110 unabhängige Bewegung in Y-Richtung bewegt werden kann, um somit eine bessere Erreichbarkeit für die optische Inspektion von einzelnen Bereichen der Oberfläche des Substrats zu ermöglichen.

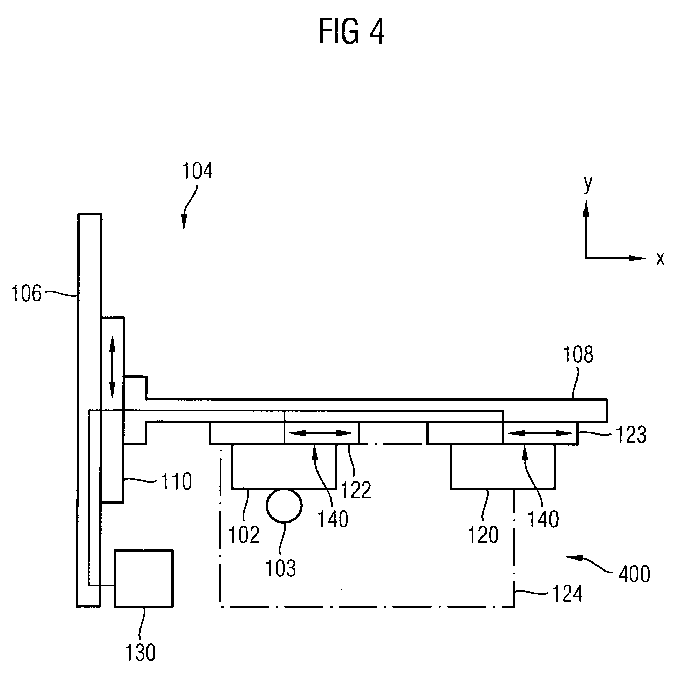

Im vierten Ausführungsbeispiel eines Bestückautomaten 400, wie in Fig. 4 dargestellt, wird am x-Träger 108, der wiederum über den y-Schlitten 110 in Y-Richtung entlang des y-Trägers 106 beweglich angeordnet ist, in Y-Richtung auf der gleichen Seite des x-Trägers 108 an jeweils separaten x-Schlitten 122, 123 die Bauelementehalteeinrichtung 102 und die Kamera 120 des optischen Inspektionssystems befestigt. Auch in diesem Ausführungsbeispiel lassen sich somit der Bestückvorgang und die optische Inspektion parallelisieren und somit einen Zeitvorteil erreichen.

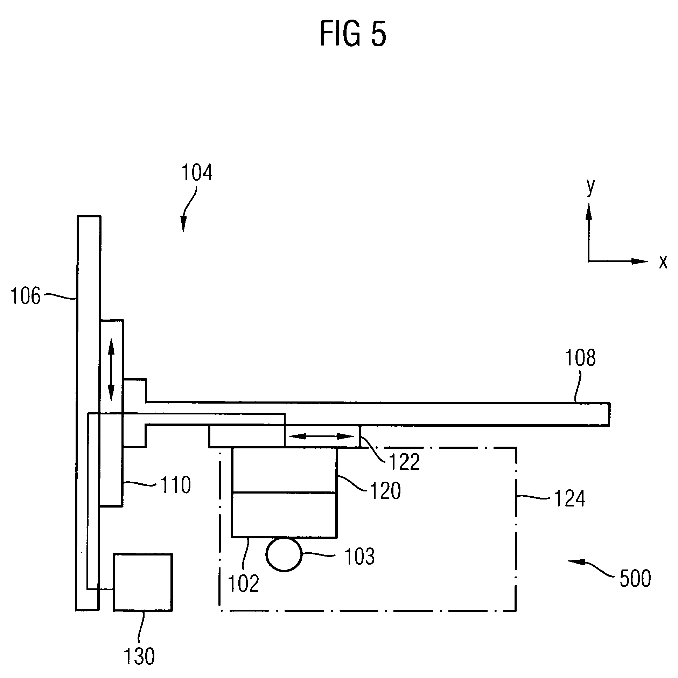

Im fünften Ausführungsbeispiel eines Bestückautomaten 500, wie in Fig. 5 dargestellt, befinden sich die Kamera 120 und die Bauelementehalteeinrichtung 102 in Y-Richtung an einer Seite des Trägers 108 an einem Schlitten 122. Auf diese Weise wird nur ein Schlitten 122 verwendet, was zu einer weiteren Kosteneinsparung führt.

Die vorgeschlagene Vorrichtung und das vorgeschlagene Verfahren beinhalten die Kombination einer Automated-Optical-Inspection mit einer Bauelementehalteeinrichtung, beispielsweise einem Bestückkopf für die Oberflächenmontage von Bauelementen bzw. einem Greifer, auf einem oder unterschiedlichen Portalen bzw. Trägern in jeweils einem Bestückautomaten. Dabei kann eine standardisierte Schnittstelle von der Bauelementehalteeinrichtung bzw. der Kamera zum jeweiligen Schlitten 122, 123 bzw. zum jeweiligen Träger 108, 109 vorgesehen sein, um verschiedene Konfigurationen zu ermöglichen und einfach zwischen verschiedenen Konfigurationen zu wechseln.

Durch das vorgeschlagene Verfahren bzw. die vorgeschlagene Vorrichtung wird die Fertigungsfläche reduziert und es entstehen geringere Anschaffungskosten bei der Verwendung einer partiellen AOI-Funktion in einem Fertigungsprozess von Substraten, beispielsweise Leiterplatten. In einfacher Weise lässt sich die Maschinenkonfiguration um eine Automated-Optical-Inspection in Bestückautomaten durch Benutzung der bereits vorhandenen technischen Infrastruktur erweitern.

Die Ergebnisse der optischen Inspektion können dann auch verwendet werden, um beispielsweise noch die Position eines ungenau gesetzten Bauelementes im Bestückautomaten durch Wiederaufnehmen und Neuabsetzen zu korrigieren, oder um bei nachfolgenden Substraten genauere Bestückungen zu ermöglichen.

Es entstehen neue Konfigurationsmöglichkeiten der Bestückautomaten mit Bestückköpfen und Automated-Optical-Inspection-Scannern auf einem oder zwei Trägern.

## Patentansprüche

1. Vorrichtung (100, 300) zum Bestücken von Substraten (124, 125, 126) mit Bauelementen mit
- einem x-y-Positioniersystem (104), welches einen x-Träger (108, 109) aufweist,
- mindestens einer Bauelementehalteeinrichtung (102), die beweglich an dem x-Träger (108, 109) angeordnet ist,
- einem optischen Inspektionssystem zur Inspektion des Substrates, welches mindestens eine Kamera (120) aufweist, die beweglich an dem x-Träger (108, 109) angeordnet ist,
**dadurch gekennzeichnet, dass**
die Bauelementehalteeinrichtung (102) und die Kamera (120) an verschiedenen Längsseitenflächen des länglichen x-Trägers angeordnet sind.

2. Vorrichtung (100) nach Anspruch 1,
**dadurch gekennzeichnet, dass**
die Kamera (120) und die Bauelementehalteeinrichtung (102) an einem gemeinsamen x-Schlitten (122) gemeinsam beweglich am Träger (108) angeordnet sind.

3. Vorrichtung (300) nach Anspruch 1,
**dadurch gekennzeichnet, dass**
die Kamera (120) und die Bauelementehalteeinrichtung (102) jeweils an einem separaten Schlitten (122, 123) am Träger (108) angeordnet sind.

4. Vorrichtung (100, 300) nach einem der Ansprüche 1 bis 3,
**dadurch gekennzeichnet, dass**
eine standardisierte elektrische und/oder mechanische Schnittstelle (140) für die Bauelementehalteeinrichtung (102) bzw. für die Kamera (120) am x-Schlitten (122, 123) vorgesehen ist.

5. Vorrichtung (100, 300) nach einem der Ansprüche 1 bis 4,
**dadurch gekennzeichnet, dass**
eine Steuereinrichtung (130) vorgesehen ist zum Auswerten von Inspektionsergebnissen des optischen Inspektionssystems und zum Berücksichtigen der Inspektionsergebnisse bei nachfolgenden Bestückvorgängen mit der Bauelementehalteeinrichtung (102).

6. Vorrichtung (100, 300) nach einem der Ansprüche 1 bis 5,
**dadurch gekennzeichnet, dass**
dass die Kamera (102) als Automated-Optical-Inspection-Scanner ausgebildet ist.

7. Verfahren zum Bestücken von Substraten (124, 125, 126) mit Bauelementen bei dem mittels einer an einem x-Träger (108) eines x-y-Positioniersystems (104) angeordneten Bauelementehalteeinrichtung (102) Bauelemente aus Zuführeinheiten entnommen und auf einem Substrat (124, 125, 126) abgesetzt werden, wobei
mittels einer am x-y-Positioniersystem (104) beweglich angeordneten Kamera (120) eine optische Inspektion von zumindest Teilen der Oberfläche des Substrats (124, 125, 126) erfolgt, **dadurch gekennzeichnet, dass**
unterschiedliche Kameras (120) für unterschiedliche Inspektionsaufgaben vorgesehen sind und die jeweils geeignete Kamera (120) für die jeweilige Inspektionsaufgabe ausgewählt und beweglich am x-y-Positioniersystem (104) angeordnet wird.

8. Verfahren nach Anspruch 7,
**dadurch gekennzeichnet, dass**
die optische Inspektion vor dem Bestücken des Substrats (124, 125, 126) erfolgt.

9. Verfahren nach einem der Ansprüche 7 oder 8,
**dadurch gekennzeichnet, dass**
die optische Inspektion während des Bestückens des Substrats (129, 125, 126) erfolgt.

10. Verfahren nach Anspruch 9,
**dadurch gekennzeichnet, dass**
die Bestückposition während der Bestückung des Substrats (124, 125, 126) aufgrund eines Ergebnisses der optischen Inspektion korrigiert wird.

11. Verfahren nach einem der Ansprüche 7 bis 10,
**dadurch gekennzeichnet, dass**
die optische Inspektion nach dem Bestücken des Substrats (124, 125, 126) erfolgt.

12. Verfahren nach einem der Ansprüche 7 bis 11,
**dadurch gekennzeichnet, dass**
die optische Inspektion auf der gesamten Oberfläche des Substrats (124, 125, 126) erfolgt.

13. Verfahren nach einem der Ansprüche 7 bis 12,
**dadurch gekennzeichnet, dass**
die optische Inspektion in ausgewählten Bereichen auf der Oberfläche des Substrats (124, 125, 126) erfolgt.

14. Verfahren nach einem der Ansprüche 7 bis 12,
**dadurch gekennzeichnet, dass**
die optische Inspektion nur bei ausgewählten Bauelementen nach der Bestückung dieser ausgewählten Bauelemente erfolgt.

15. Verfahren nach einem der Ansprüche 7 bis 14,
**dadurch gekennzeichnet, dass**
eine Kamera (120) für die optische Inspektion unabhängig von der Bauelementehalteeinrichtung (102) am x-y-Positioniersystem (104) bewegt wird.

16. Verfahren nach einem der Ansprüche 7 bis 15,
**dadurch gekennzeichnet, dass**
Ergebnisse des optischen Inspektionssystems ausgewertet werden und die Ergebnisse für nachfolgende Bestückprozesse benutzt werden.

## Claims

1. Apparatus (100, 300) for assembling substrates (124, 125, 126) with components, comprising
an x-y positioning system (104), which comprises an x-carrier (108, 109),
at least one component holding device (102), which is arranged at the x-carrier (108, 109) in a movable manner,
an optical inspection system for inspection of the substrate, which comprises at least one camera (120), which is arranged at the x-carrier (108, 109) in a movable manner,
**characterized in that**
the component holding device (102) and the camera (120) are arranged at different long side areas of the longish x-carrier.

2. Apparatus (100) according to claim 1,
**characterized in that**
the camera (120) and the component holding device (102) are arranged in a common movable manner at a common x-sliding carriage (122) at the carrier (108).

3. Apparatus (100) according to claim 1,
**characterized in that**
the camera (120) and the component holding device (102) are respectively arranged at a separate sliding carriage (122, 123) at the carrier (108).

4. Apparatus (100, 300) according to one of the claims 1 to 3,
**characterized in that**
a standardized electrical and/or mechanical interface (140) is provided for the component holding device (102) respectively for the camera (120) at the x-sliding carriage (122, 123).

5. Apparatus (100, 300) according to one of the claims 1 to 4,
**characterized in that**
a control device (130) is provided to evaluate inspection results of the optical inspection system and to consider the inspection results for subsequent assembling procedures with the component holding device (102).

6. Apparatus (100, 300) according to one of the claims 1 to 5,
**characterized in that**
the camera (102) is formed as an automated optical inspection scanner.

7. Method for assembling substrates (124, 125, 126) with components, wherein components are taken from feeding units and are deposited on a substrate (124, 125, 126) by means of a component holding device (102) arranged at an x-carrier (108) of an x-y positioning system (104), wherein
an optical inspection of at least of parts of the surface of the substrate (124, 125, 126) is effected by means of a camera (120) which is arranged at the x-y positioning system (104) in a movable manner,
**characterized in that**
different cameras (120) are provided for different inspection tasks and the respective appropriate camera (120) is chosen for the respective inspection task and is arranged at the x-y positioning system (104) in a movable manner.

8. Method according to claim 7,
**characterized in that**
the optical inspection is effected prior to assembling of the substrate (124, 125, 126).

9. Method according to one of the claims 7 or 8,
**characterized in that**
the optical inspection is effected during assembling of the substrate (124, 125, 126).

10. Method according to claim 9,
**characterized in that**
the assembly position is corrected during the assembly of the substrate (124, 125, 126) due to a result of the optical inspection.

11. Method according to one of the claims 7 to 10,
**characterized in that**
the optical inspection is effected after assembling of the substrate (124, 125, 126).

12. Method according to one of the claims 7 to 11,
**characterized in that**
the optical inspection is effected on the whole surface of the substrate (124, 125, 126).

13. Method according to one of the claims 7 to 12,
**characterized in that**
the optical inspection is effected in selected areas on the surface of the substrate (124, 125, 126).

14. Method according to one of the claims 7 to 12,
**characterized in that**
the optical inspection is effected only with selected components after assembling these selected components.

15. Method according to one of the claims 7 to 14,
**characterized in that**
a camera (120) is moved independently from the component holding device (102) at the x-y positioning system (104) for the optical inspection.

16. Method according to one of the claims 7 to 15,
**characterized in that**
results of the optical inspection system are evaluated and the results are used for subsequent assembling processes.

## Revendications

1. Dispositif (100, 300) servant à implanter des substrats (124, 125, 126) avec des composants, comprenant
- un système de positionnement x-y (104), qui présente un support x (108, 109),
- au moins un équipement de maintien de composant (102), qui est disposé de manière mobile sur le support x (108, 109),
- un système d'inspection optique servant a inspecter le substrats, lequel système d'inspection présente une caméra (120) disposée de manière mobile sur le support x (108, 109),
**caractérisé en ce que**
l'équipement de maintien de composant (102) et la caméra (120) sont disposés sur diverses surfaces latérales longitudinales du support x allongé.

2. Dispositif (100) selon la revendication 1,
**caractérisé en ce que**
la caméra (120) et l'équipement de maintien de composant (102) sont disposés conjointement de manière mobile sur le support (108), sur un chariot x (122) commun.

3. Dispositif (300) selon la revendication 1,
**caractérisé en ce que**
la caméra (120) et l'équipement de maintien de composant (102) sont disposés sur le support (108), respectivement sur un chariot (122, 123) séparé.

4. Dispositif (100, 300) selon l'une quelconque des revendications 1 à 3,
**caractérisé en ce que**
une interface (140) normalisée électrique et/ou mécanique est prévue sur le chariot x (122, 123) pour l'équipement de maintien de composant (102) ou pour la caméra (120).

5. Dispositif (100, 300) selon l'une quelconque des revendications 1 à 4,
**caractérisé en ce que**
un équipement de commande (130) est prévu pour évaluer des résultats d'inspection du système d'inspection optique et pour tenir compte des résultats d'inspection lors des procédures d'implantation qui suivent avec l'équipement de maintien de composant (102).

6. Dispositif (100, 300) selon l'une quelconque des revendications 1 à 5,
**caractérisé en ce que**
la caméra (102) est réalisée comme un scanner d'inspection optique automatisée.

7. Procédé servant à implanter des substrats (124, 125, 126) avec des composants, dans le cadre duquel des composants sont prélevés des unités d'amenée et sont déposés sur un substrat (124, 125, 126) au moyen d'un équipement de maintien de composant (102) disposé sur un support x (108) d'un système de positionnement x-y (104), dans lequel
une inspection optique au moins de parties de la surface du substrat (124, 125, 126) est effectuée au moyen d'une caméra (120) disposée de manière mobile sur le système de positionnement x-y (104),
**caractérisé en ce que**
diverses caméras (120) sont prévues pour les diverses missions d'inspection, et **en ce que** la caméra (120) respectivement appropriée pour la tâche d'inspection respective est choisie et est disposée de manière mobile sur le système de positionnement x-y (104).

8. Procédé selon la revendication 7,
**caractérisé en ce que**
l'inspection optique est effectuée avant l'implantation du substrat (124, 125, 126).

9. Procédé selon l'une quelconque des revendications 7 ou 8,
**caractérisé en ce que**
l'inspection optique est effectuée pendant l'implantation du substrat (124, 125, 126).

10. Procédé selon la revendication 9,
**caractérisé en ce que**
la position de l'implantation est corrigée pendant l'implantation du substrat (124, 125, 126) du fait d'un résultat de l'inspection optique.

11. Procédé selon l'une quelconque des revendications 7 à 10,
**caractérisé en ce que**
l'inspection optique est effectuée après l'implantation du substrat (124, 125, 126).

12. Procédé selon l'une quelconque des revendications 7 à 11,
**caractérisé en ce que**
l'inspection optique est effectuée sur l'intégralité de la surface du substrat (124, 125, 126).

13. Procédé selon l'une quelconque des revendications 7 à 12,
**caractérisé en ce que**
l'inspection optique est effectuée dans des zones sélectionnées sur la surface du substrat (124, 125, 126).

14. Procédé selon l'une quelconque des revendications 7 à 12,
**caractérisé en ce que**
l'inspection optique n'est effectuée que pour quelques composants sélectionnés après l'implantation desdits composants sélectionnés.

15. Procédé selon l'une quelconque des revendications 7 à 14,
**caractérisé en ce que**
une caméra (120) est déplacée pour l'inspection optique sur le système de positionnement x-y (104) indépendamment de l'équipement de maintien de composant (102).

16. Procédé selon l'une quelconque des revendications 7 à 15,
**caractérisé en ce que**
des résultats du système d'inspection optique sont évalués, et **en ce que** les résultats sont utilisés pour les processus d'implantation suivants.
